(19) Europäisches Patentamt
European Patent Office
Office européen des brevets

(11) **EP 0 810 736 B1**

(12) **EUROPEAN PATENT SPECIFICATION**

(45) Date of publication and mention
of the grant of the patent:
**11.08.2004 Bulletin 2004/33**

(51) Int Cl.[7]: **H03L 7/087**, H03L 7/183

(21) Application number: **97108716.8**

(22) Date of filing: **30.05.1997**

(54) **PLL frequency synthesizer**

PLL-Frequenzsynthetisierer

Synthétiseur de fréquence à PLL

(84) Designated Contracting States:
**DE GB IT NL SE**

(30) Priority: **29.05.1996 JP 13451596**

(43) Date of publication of application:
**03.12.1997 Bulletin 1997/49**

(73) Proprietor: **NEC CORPORATION**
**Tokyo (JP)**

(72) Inventor: **Jokura, Jun**
**Minato-ku, Tokyo (JP)**

(74) Representative:
**von Samson-Himmelstjerna, Friedrich R.,**
**Dipl.-Phys. et al**
**SAMSON & PARTNER**
**Widenmayerstrasse 5**
**80538 München (DE)**

(56) References cited:
**EP-A- 0 526 227          EP-A- 0 566 274**
**US-A- 5 254 959**

• **ADACHI H. ET AL.: "High-Speed Frequency**
**Switching Synthesizer Using Fractional N Phase**
**Locked Loop" TRANSACTIONS OF THE**
**INSTITUTE OF ELECTRONICS, INFORMATION**
**AND COMMUNICATIONS ENGINEERS C-I, vol.**
**76C-I, no. 11, November 1993, JAPAN, pages**
**445-452, XP000602945**

## Description

## BACKGROUND OF THE INVENTION

The present invention relates to a phase-locked loop (PLL) frequency synthesizer, and in particular to a PLL frequency synthesizer which is suitable for use in a communication system in which the channel interval is small.

## Description of the Prior Art

In general, in order to cope with a great deal of the measure of capacity for the communication system, a channel interval is set to a small value. Thus in cases where the channel interval is small, the ratio of frequency division of the PLL loop constituting a PLL frequency synthesizer becomes large. However, the reference frequency which is compared with another one becomes low. The implementation of a high-speed operation is difficult, with the result that it takes a lot of time for switching the frequency (channel switch).

The document ARTICLE OF INSTITUTE OF ELECTRONIC INFORMATION COMMUNICATION November 1993, C-1, Vol. J76-C-I, No. 11, pages 445 - 452, H. ADACHI ET AL. "High-Speed Frequency Switching Synthesizer Using Fractional N Phase Locked Loop" discloses a technique of a high-speed frequency switching of a PLL frequency synthesiser for use in a communication equipment of a communication system in which the channel interval is small.

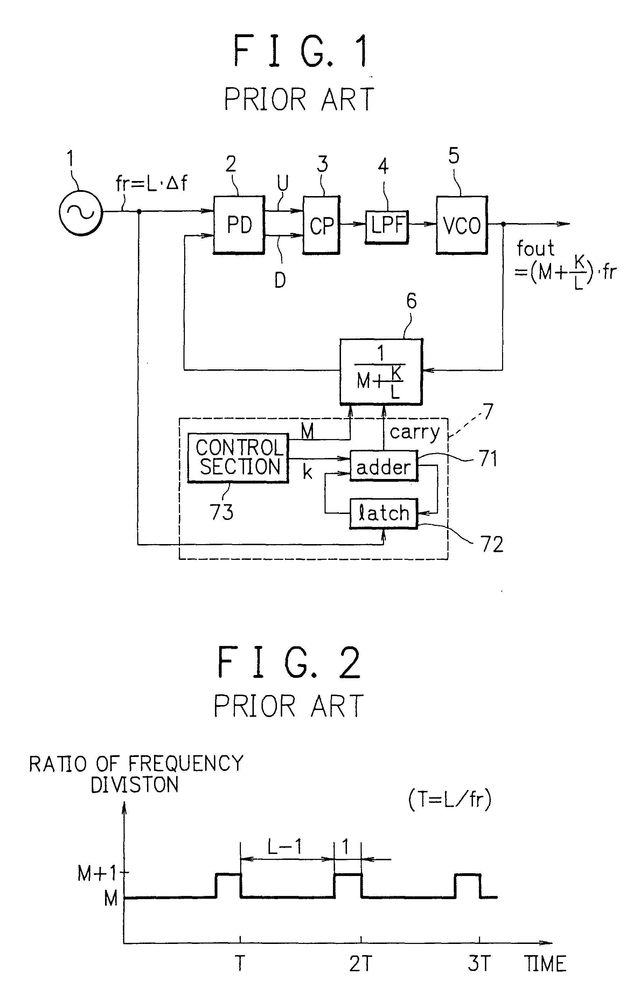

Fig. 1 is a block diagram of the frequency synthesizer disclosed in the above article. Referring to Fig. 1, one input of the phase comparator 2 is for the reference signal from the oscillator having the frequency fr. The other inputs applied thereto are signals which are formed by dividing the frequency of the oscillation output of the VCO (Voltage Controlled Oscillator) 5 by means of the frequency divider 6.

A pair of the comparison output U, D of the phase comparator 2 comes as the control voltage to the VCO 5 through the charge pump 3 and the loop filter 4. Here U and D represent the absolute value and the sign of the phase difference, respectively, and also represent the lead (U) or the delay (D) of the signal.

The frequency divider 6 takes the fractional value {1/(M + k/L)} as the ratio of frequency division. The ratio of frequency division is controlled by the accumulator 7 consisting of an adder 71, a latch 72, and a control section 73.

The output of the adder 71 is latched in the latch 72 in synchronism with the reference frequency fr of the reference signal thus increasing an addition output by k.

When the adder 71 comes into over-flow, the frequency division ratio becomes M + 1. When the over-flow does not occur, the frequency division ratio maintains M.

It takes 1 clock for 1 cycle (1/f) of the reference signal. As shown in Fig. 2, during L clocks (time T), the frequency division ratio M is changed to M + 1 only once. At this time, an average value of the ratio of frequency division over the time T becomes M + 1/L. Since 1/L can be considered as K/L which is expanded, let k stands for 0, 1, 2, ···, thus the ratio of frequency division in terms of 1/L step is capable of being decided.

Hereinafter, KPD indicates the sensitivity of the phase comparator 2, Kv the sensitivity of the VCO, fout the output frequency, and fr the reference frequency. A loop gain Ko becomes:

$$Ko = Kv \cdot KPD/N = Kv \cdot KPD/(fout/fr)$$

consequently, the loop gain Ko becomes a large value when N is small, namely fr is large. It becomes possible to shorten the convergence time.

In the fractional N phase locked loop shown in Fig. 1, the ratio of frequency division changes in regarding the time T as the reference cycle. Thereby, the frequency component 1/T and multiples thereof appear as an output of the phase comparator. Thus, the output signal of the VCO is modulated.

As a result, there is the problem that high-level spurious is generated in the neighborhood of the center frequency of the output signal.

Document US-A-5,254,959 shows all features of the preamble of claim 1.

## SUMMARY OF THE INVENTION

In view of the foregoing, it is an object of the present invention to provide a PLL frequency synthesizer which is capable of changing high-speed channel switch without generating spurious in the large capacity communication system having a small channel interval and using a high reference frequency.

According to the present invention, for achieving the above-mentioned object, there is provided a PLL (Phase Locked Loop) frequency synthesizer which comprises voltage control oscillation means (5) for generating an oscillation signal; n phase comparison means, n being an integer number higher than 2; n oscillation signal frequency-division means for dividing the frequency of the oscillation signal, the frequency divided oscillation signal from each of said n oscillation signal frequency division means being respectively supplied to a first input of a corresponding one of said n phase comparison means; control voltage generating means for generating a control voltage of said voltage control oscillation means in response to output signals of said n phase comparison means; and control means for controlling the activation in turn of said n oscillation signal frequency-division means; characterised by further comprising: n reference signal frequency-division means for dividing the frequency of the reference signal, the frequency divided reference signal from each of said n reference signal frequency-division means being respectively supplied to a second input of a corresponding one of said n phase comparison means; whereby the control means are further arranged for controlling the successive activation of n groups of frequency dividers in response to a channel changing instruction, each group of frequency dividers comprising one of said n oscillation signal frequency division means and one of said n reference signal frequency division means which are connected to a same phase comparison means among said n phase comparison means, whereby the activation delay between two groups of dividers to be successively activated is equal to one cycle interval of said reference signal.

Preferably, there is provided a PLL frequency synthesizer wherein each of the phase comparison means has a function for generating a phase synchronization detecting signal at the time of a phase synchronization state, the control means further control the deactivation of all of the other phase comparison means except of the phase comparison means generating the phase synchronization detecting signal, and of all of the other corresponding oscillation signal frequency-division means and reference signal frequency-division means.

As stated above, there is provided a plurality of groups (n groups) of frequency dividers for subjecting the reference frequency and the Frequency of the output of the VCO to n frequency divisions, and a plurality of phase comparators (n phase comparators) for comparing the phases of the frequency divided outputs thereof. These n groups are delayed in turn by 1 cycle of the reference frequency. The phase comparison outputs of these n phase comparators are superposed, thus establishing the VCO control voltage through the charge pump and the LPF (loop filter).

Since the phase difference signal actually sent to the charge pump is the signal in which all n phase comparators output signals are superposed, the apparent comparison frequency of the PLL system becomes the former frequency of 1/n of the reference frequency. Consequently it is capable of corresponding in high-speed to a system having a small channel interval remaining in a high reference frequency.

The above and further objects and novel features of the invention will be more fully understood from the following detailed description when the same is read in connection with the accompanying drawings. It should be expressly understood, however, that the drawings are for purpose of illustration only and are not intended as a definition of the limits of the invention.

## BRIEF DESCRIPTION OF THE DRAWINGS

Fig. 1    is a view showing an example of the conventional PLL frequency synthesizer;

Fig. 2    is a view showing block operation of Fig. 1;

Fig. 3    is a block diagram showing one embodiment according to the present invention; and

Fig. 4    is a timing chart showing operation of the embodiment of the invention.

## DETAILED DESCRIPTION OF THE PREFERRED EMBODIMENTS

A preferred embodiment of the invention will now be described in detail referring to the accompanying drawings.

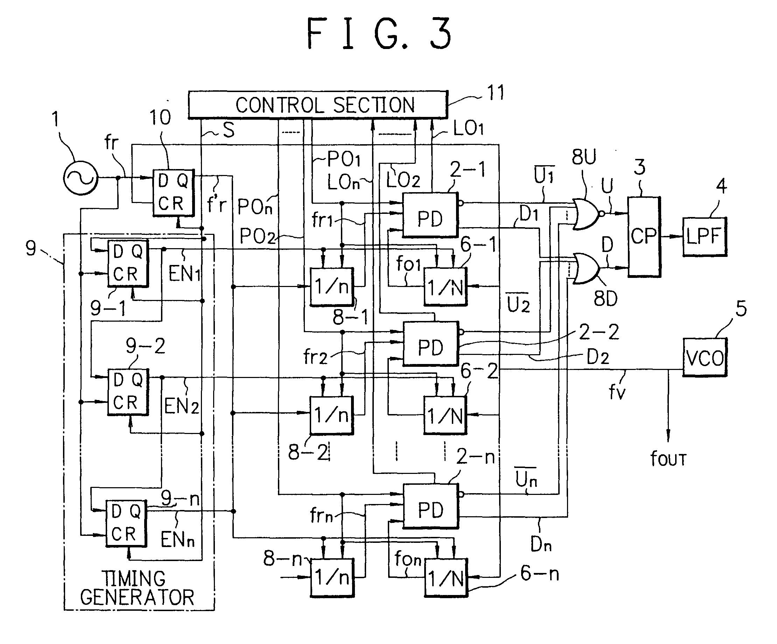

Fig. 3 is a block diagram of one embodiment of the invention. The same portions as those of Fig. 1 are indicated by the same signs. In Fig. 3, n-unit of frequency dividers 8.1 to 8.n which implement 1/n frequency division on a referenc frequency fr of oscillation signal of an oscillator 1 are provided. Furthermore, n-unit of frequency dividers 6.1 to 6.n which implement 1/N-frequency division on oscillation cycle fv of VCO5 are provided.

N-unit of phase comparators 2.1 to 2.n are provided. The comparator 2.1 implements phase comparison of both frequency division outputs of the frequency divider 8.1 and the frequency divider 6.1. The comparator 2.2 implements phase comparison of both frequency division outputs of the frequency divider 8.2 and the frequency divider 6.2. In the same manner as above procedure, the comparator 2.n implements phase comparison of both frequency division outputs of the frequency divider 8.n and the frequency divider 6.n.

Each of the phase comparators which is similar to that of Fig. 1 as the conventional example generates a pair of comparison out put U and D, particularly in this embodiment, an inverted value as output U indicating a lead phase difference is derived.

All of the inverted values of the comparison output U are subjected to inclusive OR superposition at NOR-gate 8U. All of the comparison output D are subjected to inclusive OR superposition at OR-gate 8D. These superposition outputs are inputted to a charge pump 3 each. The output of the charge pump 3 comes into control voltage of VCO5 through loop filter 4.

Oscillation output fr of the oscillator 1 is not directly applied to n-unit of the frequency dividers 8.1 to 8.n. The output fr is inputted to D-type FF (flip-flop) 10 for re-timing. The output fr is subjected to re-timing by the oscillation output fv of the VCO5 into fr', thus being inputted to n pieces of the frequency dividers 8.1 to 8.n each.

A timing generator 9 responds to a set signal S from the control section 11. The timing generator 9 generates n pieces of timing signals EN1 to ENn. N pieces of timing signals EN1 to ENn lag in turn by each one-period (1/fr) of the oscillation output fr of the oscillator 1 to come into active. The timing generator 9 is composed of n-stages of D-type FF (flip-flop) 9.1 to 9.n connected continuously with each other. Input of the n-stages of D-type FF is that the set signal S is reset-input (R), and the reference frequency fr is clock-input (CK).

The set signal S is inputted to a data-input of the first-stage FF 9.1. The output Q thereof comes into a data-input of the next-stage FF 9.2. And then the output Q of the front-stage becomes in turn a data-input. Each output Q of these n-stages FF 9.1 to 9.n comes into timing signals EN1 to ENn.

The timing signal EN1 implements activation both of the frequency divider 6.1 and the frequency divider 8.1. The timing signal EN2 implements activation both of the frequency divider 6.2 and the frequency divider 8.2. And then in the same manner as above procedure, the timing signal ENn implements activation both of frequency divider 6.n and the frequency divider 8.n.

The control section 11 responds to a channel change instruction, thus generating the set signal S. The control section 11 implements reset of re-timing FF 10, and reset of each FF 9.1 to 9.n of the timing generator 9.

The control section 11 takes an input for phase lock detection signals LO1 to LOn of the phase comparators 2.1 to 2.n each. M is in either whole number of 1 to n, when phase lock is detected in m-th phase comparator 2.m, power supply OFF signal PO is generated. The power supply OFF signal changes whole phase comparators and frequency divider except for the m-th phase comparator 2.m and the m-th frequency dividers 6.m and 8.m into non-activated state.

Each of the phase comparators 2.1 to 2.n has a function of generating lock detection signals LO1 to LOn when both input signals from the frequency divider come into phase lock state.

In this constitution, there are provided n-unit of phase comparators, n-unit of VCO oscillation signal frequency dividers (called as feedback frequency divider) inputting to the phase comparator, and n-unit of reference oscillation signal frequency dividers. Namely there are provided n-set (n-system) of these circuits. The frequency dividers 6.1 to 6.n of each set divide VCO output frequency fv into 1/N. The frequency dividers 8.1 to 8.n of each set divide reference oscillation frequency fr' into 1/n. Both of them have a function that it causes each frequency to drop to channel space $\Delta f$ (= fr'/n, fv/N).

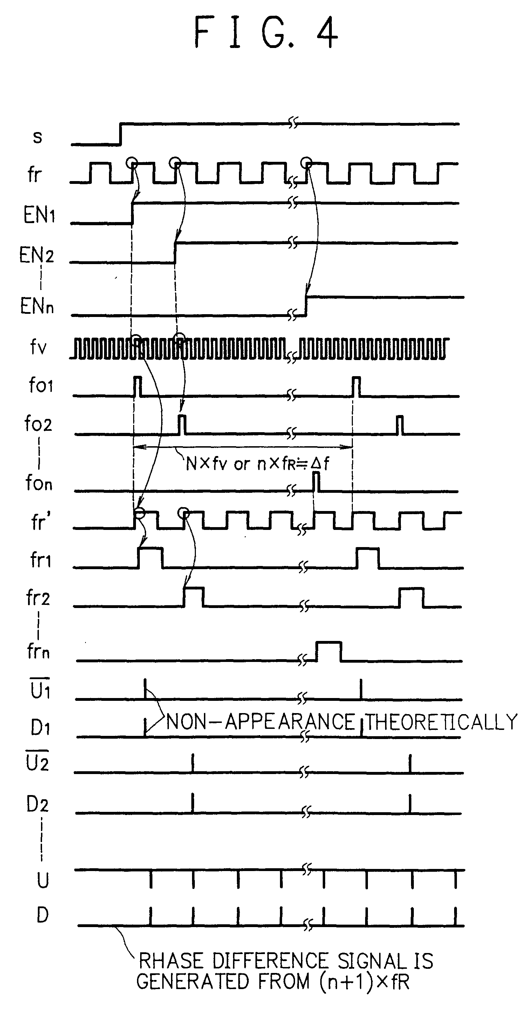

As shown in operation timing chart of Fig. 4, each of the frequency dividers respond to the set signal S. Each of the frequency dividers is activated by the timing signal EN1 to ENn which are generated in turn synchronized with each rising of the reference signal fr.

Here, there is supposed that example of PLL synchronization in which channel space is 200KHz, output frequency is 999.8MHz. This case results in N = 4999. And when n = 5 is selected, this case results in fr = n× 200KHz = 1MHz. The timing signals EN1 to ENn rise in every 1MHz (coming into enable).

When fv is 999.8MHz≦ fv < 1GHz, rising interval of pulses of f01 to f05 correspond to 1000-cycle of fv. However second pulse of f01 after f05 does not correspond to 1000th cycles but 999th cycles.

Furthermore, when fv is 999.75MHz ≦ fv <999.8MHz, space between f04 and f05 corresponds to 999-cycle of fv. In the same manner as above, when fv is 999.67MHz ≦ fv < 999.75MHz, only space between f03 and f04 corresponds to 999-cycle of fv.

As stated above, when fv is in 999MHz ≦ fv < 1001MHz, space of f01 to f05 is related to 1000±1-cycle of fv.

While, fr1 to fr5 are similar to those of above cases. When fv is 999.75 ≦ fv < 999.8MHz, rising interval of pulse of fr1 to fr5 becomes 999-cycle only in case of fr4 to fr5.

In the phase comparison between f0i and fri (i = 1 to 5), each of the leading edges corresponding to the first pulse of the pulses f01, fR1 responding to the rising timing of the set signal S is of relationship of always the same phase due to operation of re-timing FF 10, thereby the phase comparison output is generated after each of the second pulse of f01, fr1. Phase comparison output generated by each phase comparator is subjected to the inclusive OR superposition at the OR-gates 8U, 8D thus coming into driving signal to the charge pump 3.

Each phase comparison output is generated based upon the phase relationship of each of fri, f0i after n×fri, n×f0i from initial input of fri, f0i. Namely the phase comparison signal is generated synchronously at the time of pulse generation of the fr' each. The generating cycle thereof comes into 1/fr on average.

Based on the relationship of fr = n×$\Delta f$ , the reference frequency fr is established to n times of $\Delta f$ of the channel space.

In the control section 11, the set signal comes into enable when channel switch is directed. At the time when it is ascertained that a phase difference is entered into prescribe tolerance (phase locked condition) in the phase comparison of either system in n-systems of the phase comparators 2.1 to 2.n (either of LO1 to LOn comes into enable), it causes all systems of the phase comparators exception for this phase comparator to control to be non-activated.

For this reason, the signal PO which causes a power source of systems exception for the system in which the phase lock is detected to switch into off is generated by the control section 11. As a result, after entrance into convergence synchronism, only both of the phase comparator in the phase locked system, and single system of frequency divider operate continuously. The synchronism is maintained by the PLL loop of the reference frequency due to the phase comparison output with 1/$\Delta f$ cycle.

When the channel change is implemented again, whole phase comparison systems are switched on (activation) and the set signal S comes into enable. Again each frequency divider rises with delaying of every 1/fr cycle. It permits the reference frequency of the phase comparison to rise to $n \times \Delta f$ in apparent. High speed switch comes into possible. The frequency division ratio N comes into variable by virtue of the channel change.

As described above, according to the present invention, there are provided n-systems of the phase comparison system which operate on the reference frequency $\Delta f$ of the channel interval. It causes n-systems of phase comparison system to shift by $(1/n)\Delta f$, thus generating the phase comparison output of each system. Each of these phase comparison outputs which are superposed is employed exception for the fractional frequency division method. Thereby the reference frequency of the PLL-system is capable of being seemingly high established by $n \times \Delta f$. Accordingly, there is the effect that the high-speed switch comes into possible.

Furthermore, after converging, it renders all of the power source excluding one-system of phase comparison system into OFF, so that operation thereof is implemented under the reference frequency $\Delta f$, thereby there is the effect that the noise characteristic in synchronous state is improved.

While preferred embodiments of the invention have been described using specific terms, such description is for illustrative purpose only, and it is to be understood that changes and variations may be made without departing from the scope of the following claims.

## Claims

1. A PLL frequency synthesizer comprising:

   voltage control oscillation means (5) for generating an oscillation signal;
   n phase comparison means (2.1-2.n), n being an integer number higher than 2;
   n oscillation signal frequency-division means (6.1-6.n) for dividing the frequency of the oscillation signal, the frequency divided oscillation signal from each of said n oscillation signal frequency division means being respectively supplied to a first input of a corresponding one of said n phase comparison means (2.1-2.n);
   control voltage generating means for generating a control voltage of said voltage control oscillation means (5) in response to output signals of said n phase comparison means (2.1-2.n); and
   control means (9, 11) for controlling the activation in turn of said n oscillation signal frequency-division means (6.1-6.n);

   **characterised by** further comprising:

   n reference signal frequency-division means (8.1-8.n) for dividing the frequency of a reference signal, the frequency divided reference signal from each of said n reference signal frequency-division means being respectively supplied to a second input of a corresponding one of said n phase comparison means (2.1-2.n);

   whereby the control means (9, 11) are further arranged for controlling the successive activation of n groups of frequency dividers in response to a channel changing instruction, each group of frequency dividers comprising one of said n oscillation signal frequency division means (6.1-6.n) and one of said n reference signal frequency division means (8.1-8.n) which are connected to a same phase comparison means among said n phase comparison means (2.1-2.n), whereby the activation delay between two groups of dividers to be successively activated is equal to one cycle interval of said reference signal.

2. A PLL frequency synthesizer according to claim 1, wherein each of said phase comparison means (2.1-2.n) has a function for generating a phase synchronization detecting signal at the time of a phase synchronization state, said control means (9, 11) further control the deactivation of all of the other phase comparison means (2.1-2.n) except of the phase comparison means (2.1-2.n) generating said phase synchronization detecting signal, and of all the other corresponding oscillation signal frequency-division means (6.1-6.n) and reference signal frequency-division means (8.1-8.n).

3. A PLL frequency synthesizer according to claim 1 or 2, further comprising re-timing means (10) for harmonizing a leading edge timing of said reference signal with that of the oscillation signal of said voltage control oscillation means (5).

4. A PLL frequency synthesizer according to claim 3, wherein said re-timing means (10) is a D-type flip-flop which receives said reference signal as a data input and which receives said oscillation signal as a clock input.

5. A PLL frequency synthesizer according to anyone of the foregoing claims, wherein said control voltage generating means comprises means (8U, 8D) for performing an OR operation on n output signals of the n phase comparison means (2.1-2.n), charge pump means (3) which receives the output signal of said OR operation means (8U, 8D) as an input, and loop filter means (4) which receives the output of said charge pump means (3) as an input.

## Patentansprüche

**1.** PLL-Frequenzgenerator, mit:

Spannungssteueroszillationsmittel (5) zum Erzeugen eines Oszillationssignals;
n Phasenvergleichsmittel (2.1-2.n), wobei n eine ganze Zahl größer als 2 ist;
n Oszillationssignal-Frequenzteilermittel (6.1-6.2) zum Teilen der Frequenz des Oszillationssignals, wobei das von jedem der n Oszillationssignal-Frequenzteilermittel in der Frequenz geteilte Oszillationssignal jeweils einem ersten Eingang eines jeweiligen der n Phasenvergleichsmittel (2.1-2.n) zugeführt wird;
Steuerspannungserzeugungsmittel zum Erzeugen einer Steuerspannung der Steuerspannungsoszillationsmittel (5) in Antwort auf Ausgangssignale der n Phasenvergleichsmittel (2.1-2.n); und
Steuermittel (9, 11) zum Steuern der abwechselnden Aktivierung der n Oszillationssignal-Frequenzteilermittel (6.1-6.n);

**dadurch gekennzeichnet, daß** er ferner umfaßt:

n Referenzsignal-Frequenzteilermittel (8.1-8.n) zum Teilen der Frequenz eines Referenzsignals, wobei das von jedem der n Referenzsignal-Frequenzteilermittel in der Frequenz geteilte Referenzsignal jeweils einen zweiten Eingang eines jeweiligen der n Phasenvergleichsmittel (2.1-2.n) zugeführt wird;

wobei die Steuermittel (9, 11) ferner zum Steuern der aufeinanderfolgenden Aktivierung von n Gruppen an Frequenzteilern in Antwort auf einen Kanaländerungsbefehl ausgestaltet sind, und jede Gruppe der Frequenzteiler eines der n Oszillationssignal-Frequenzteilermittel (6.1-6.n) und eines der n Referenzsignal-Frequenzteilermittel (8.1-8.n) umfaßt, die mit dem gleichen Phasenvergleichsmittel von dem n Phasenvergleichsmittel (2.1-2.n) verbunden sind, wobei die Aktivierungsverzögerung zwischen zwei Gruppen an Teilern, die nacheinander aktiviert werden sollen, gleich einem Zyklusintervall des Referenzsignals ist.

**2.** PLL-Frequenzgenerator nach Anspruch 1, wobei jedes der Phasenvergleichsmittel (2.1-2.n) eine Funktion zum Erzeugen eines Phasensynchronisations-Erfassungssignals zum Zeitpunkt eines Phasensynchronisationszustands hat, und die Steuermittel (9, 11) ferner die Deaktivierung all der anderen Phasenvergleichsmittel (2.1-2.n) außer dem Phasenvergleichsmittel (2.1-2.n) steuert, daß das Phasensynchronisations-Erfassungssignal erzeugt, und all der anderen entsprechenden Oszillationssignal-Frequenzteilermittel (6.1-6.n) und Referenzsignal-Frequenzteilermittel (8.1-8.n).

**3.** PLL-Frequenzgenerator nach Anspruch 1 oder 2, der ferner ein Auffrischzeitsteuerungsmittel (10) zum Abstimmen einer Zeitsteuerung mit führender Flanke des Referenzsignals mit der des Oszillationssignals der Spannungssteueroszillationsmittel (5) umfaßt.

**4.** PLL-Frequenzgenerator nach Anspruch 3, bei dem das Auffrischzeitsteuerungsmittel (10) ein D-Flip-Flop ist, das das Referenzssignal als eine Dateneingabe und das das Oszillationssignal als eine Takteingabe empfängt.

**5.** PLL-Frequenzgenerator nach einem der vorhergehenden Ansprüche, bei dem das Steuerspannungserzeugungsmittel Mittel (8U, 8D) zum Durchführen einer ODER-Operation an n Ausgangssignalen der n Phasenvergleichsmittel (2.1-2.n) der Ladungspumpenmittel (3), die das Ausgangssignal des ODER-Operationsmittels (8U, 8D) als eine Eingabe, und Schleifenfiltermittel (4) umfaßt, die die Ausgabe des Ladungspumpenmittels (3) als eine Eingabe empfängt.

## Revendications

**1.** Synthétiseur de fréquence PLL (à boucle à verrouillage de phase), comprenant :

des moyens d'oscillation de commande de tension (5) pour générer un signal d'oscillation ;
n moyens comparateurs de phases (2.1-2.n), n étant un entier supérieur à 2 ;
n moyens diviseurs de fréquence de signal d'oscillation (6.1-6.n) pour diviser la fréquence du signal d'oscillation, le signal d'oscillation à fréquence divisée issu de chacun desdits n moyens diviseurs de fréquence de signal d'oscillation étant respectivement transmis à une première entrée de l'un, correspondant, desdits n moyens comparateurs de phases (2.1-2.n) ;
des moyens générateurs de tension de commande pour générer une tension de commande desdits moyens d'oscillation de commande de tension (5) en réponse aux signaux de sortie desdits n moyens comparateurs de phases (2.1-2.n) ; et
des moyens de commande (9, 11) pour commander l'activation, à leur tour, desdits n moyens diviseurs de fréquence de signal d'oscillation (6.1-6.n) ;

**caractérisé en ce qu'**il comprend, en outre :

n moyens diviseurs de fréquence de signal de référence (8.1-8.n) pour diviser la fréquence d'un signal de référence, le signal de référence à fréquence divisée issu de chacun desdits n moyens diviseurs de fréquence de signal de référence étant respectivement transmis à une seconde entrée de l'un, correspondant, desdits n moyens comparateurs de phases (2.1-2.n) ;

grâce à quoi les moyens de commande (9, 11) sont, en outre, configurés pour commander l'activation successive de n groupes de diviseurs de fréquence en réponse à une instruction de changement de canal, chaque groupe de diviseurs de fréquence comprenant l'un desdits n moyens diviseurs de fréquence de signal d'oscillation (6.1-6.n) et l'un desdits n moyens diviseurs de fréquence de signal de référence (8.1-8.n) qui sont connectés à un même moyen comparateur de phases parmi lesdits n moyens comparateurs de phases (2.1-2.n), grâce à quoi le retard d'activation entre deux groupes de diviseurs devant être successivement activés est égal à un intervalle de cycle dudit signal de référence.

2. Synthétiseur de fréquence PLL selon la revendication 1, dans lequel chacun desdits moyens comparateurs de phases (2.1-2.n) a pour fonction de générer un signal de détection de synchronisation de phases lors d'un état de synchronisation de phases, lesdits moyens de commande (9, 11) commandent, en outre, la désactivation de tous les autres moyens comparateurs de phases (2.1-2.n), à l'exception du moyen comparateur de phases (2.1-2.n) générant ledit signal de détection de synchronisation de phases, et de tous les autres moyens diviseurs de fréquence de signal d'oscillation (6.1-6.n) et moyens diviseurs de fréquence de signal de référence (8.1-8.n).

3. Synthétiseur de fréquence PLL selon la revendication 1 ou 2, comprenant, en outre, des moyens de repositionnement temporel (10) pour harmoniser un positionnement temporel de flanc avant dudit signal de référence avec celui du signal d'oscillation desdits moyens d'oscillation de commande de tension (5).

4. Synthétiseur de fréquence PLL selon la revendication 3, dans lequel lesdits moyens de repositionnement temporel (10) sont une bascule flip-flop du type D qui reçoit ledit signal de référence en tant qu'entrée de données, et qui reçoit ledit signal d'oscillation en tant qu'entrée d'horloge.

5. Synthétiseur de fréquence PLL selon l'une quelconque des revendications précédentes, dans lequel lesdits moyens générateurs de tension de commande comprennent des moyens (8U, 8D) pour accomplir une opération logique OU sur n signaux de sortie des n moyens comparateurs de phases (2.1-2.n), des moyens de pompe à charge (3) qui reçoivent le signal de sortie desdits moyens d'opération logique OU (8U, 8D) en tant qu'entrée, et des moyens de filtre à boucle (4) qui reçoivent le signal de sortie desdits moyens de pompe à charge (3) en tant qu'entrée.

# F I G. 1
## PRIOR ART

$fr = L \cdot \Delta f$

$fout = (M + \frac{K}{L}) \cdot fr$

PD — CP — LPF — VCO

$\frac{1}{M + \frac{K}{L}}$

CONTROL SECTION

carry

adder

latch

# F I G. 2
## PRIOR ART

RATIO OF FREQUENCY DIVISION

$(T = L/fr)$

$M+1$

$M$

$L-1$

$1$

T    2T    3T    TIME

8

# FIG. 3

EP 0 810 736 B1

# F I G. 4

s

fr

EN1

EN2

ENn

fv

fo1

fo2

fon

$N \times fv$ or $n \times fR \doteqdot \Delta f$

fr'

fr1

fr2

frn

$\overline{U_1}$

D1

NON-APPEARANCE THEORETICALLY

$\overline{U_2}$

D2

U

D

RHASE DIFFERENCE SIGNAL IS
GENERATED FROM $(n+1) \times fR$